# EUROPEAN PATENT APPLICATION

(11) **EP 4 576 219 A1**
(43) Date of publication of application: **25.06.2025**
(21) Application number: 22961504.2
(22) Date of filing: 04.10.2022
(51) Int. Cl.: H01L 27/15, H01L 25/075, H01L 27/12, H01L 33/62

(54) **DISPLAY DEVICE**

(71) Applicant: LG Electronics Inc., Yeongdeungpo-gu Seoul 07336 (KR); LG Display Co., Ltd., Seoul, 07336 (KR)
(72) Inventor: CHUNG, Indo, Seoul 06772 (KR); YANG, Dohwan, Seoul 06772 (KR); KIM, Youngdo, Seoul 06772 (KR)
(74) Representative: Vossius & Partner Patentanwälte Rechtsanwälte mbB
(86) International application number: PCT/KR2022/014928
(87) International publication number: WO 2024/075859

(57) **Abstract**

The display device may comprise a substrate, a first assembly wiring and a second assembly wiring on the substrate, a partition wall disposed on the first assembly wiring and the second assembly wiring and having an assembly hole and at least one or more auxiliary hole that extends in an outer direction of the assembly hole, a semiconductor light-emitting element in the assembly hole, and a connecting electrode connected to a lateral part of the semiconductor light-emitting element. The partition wall may comprise a first partition-wall layer and a second partition-wall layer on the first partition-wall layer. An ashing rate of the first partition-wall layer may be equal to or greater than an ashing rate of the second partition-wall layer.

## Description

### [Technical Field]

The embodiment relates to a display device.

### [Background Art]

A large-area display comprises a liquid crystal display (LCD), an OLED display, and a micro-LED display.

A micro-LED display is a display that uses micro-LEDs, which are semiconductor light-emitting elements with a diameter or cross-sectional area of 100*µ*m or less, as display elements.

Since a micro-LED display uses micro-LEDs, which are semiconductor light-emitting elements, as display elements, it has excellent performance in many characteristics such as contrast ratio, response speed, color reproducibility, viewing angle, brightness, resolution, lifespan, luminescent efficiency, and luminance.

In particular, a micro-LED display has the advantage of being able to freely adjust the size or resolution because the screen may be separated and combined in a modular manner, and it has the advantage of being able to implement a flexible display.

However, since a large-area micro-LED display requires millions or more micro-LEDs, there is a technical problem that it is difficult to quickly and accurately transfer micro-LEDs to a display panel.

Recently developed transfer technologies comprise the pick and place process, the laser lift-off method, and the self-assembly method.

Among these, the self-assembly method is a method in which semiconductor light-emitting elements find their assembly positions in a fluid on their own, which is advantageous for implementing a large-screen display device.

However, research on the technology for manufacturing displays through self-assembly of micro-LEDs is still insufficient.

In particular, in a conventional technology, when rapidly transferring millions or more semiconductor light-emitting elements to a large display, the transfer speed can be improved, but the transfer error rate can increase, which causes a technical problem in that the transfer yield is low.

In the related technology, a self-assembly transfer process using dielectrophoresis (DEP) is being attempted, but there is a problem in that the self-assembly rate is low due to the unevenness of the DEP force.

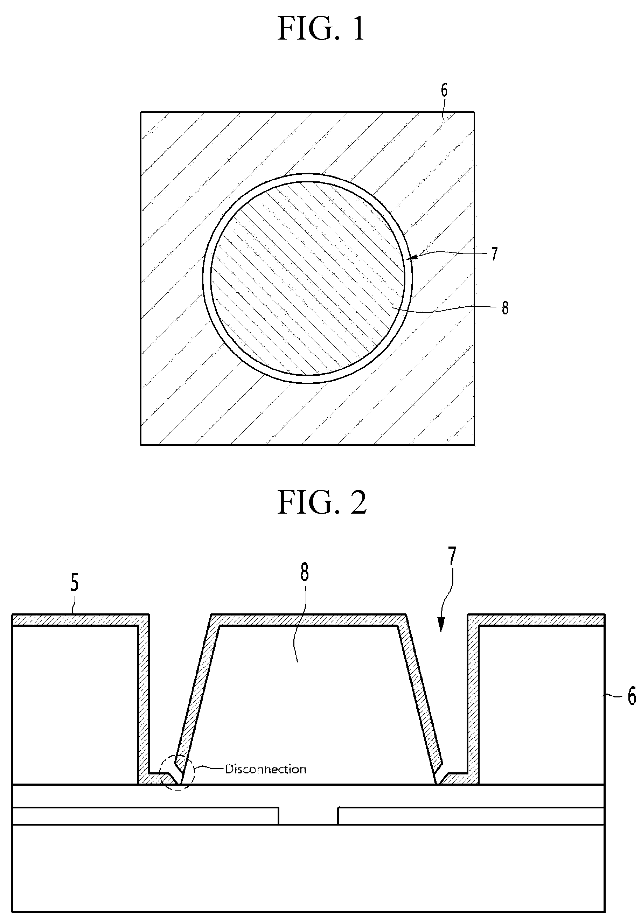

FIG. 1 is a plan view illustrating a semiconductor light-emitting element disposed in an assembly hole in a non-public internal technology.

As illustrated in FIG. 1, a semiconductor light-emitting element 8 is assembled in an assembly hole 7 provided in a partition wall 6 using self-assembly.

Thereafter, a deposition process may be performed for electrical connection of the semiconductor light-emitting element 8, so that a lateral electrode is formed between an outer side of the semiconductor light-emitting element 8 and an inner side of the assembly hole 7.

However, as shown in FIG. 2, due to the narrow gap between the outer side of the semiconductor light-emitting element 8 and the inner side of the assembly hole 7, a metal material is not easily deposited in the gap, resulting in a disconnection defect of the lateral electrode 5.

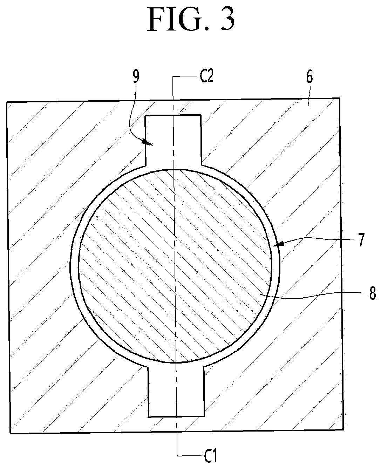

In order to prevent the disconnection defect, as illustrated in FIG. 3, an auxiliary hole 9 is additionally formed together with the assembly hole 7. Since the metal material is easily deposited by the auxiliary hole 9, the disconnection defect of the lateral electrode does not occur.

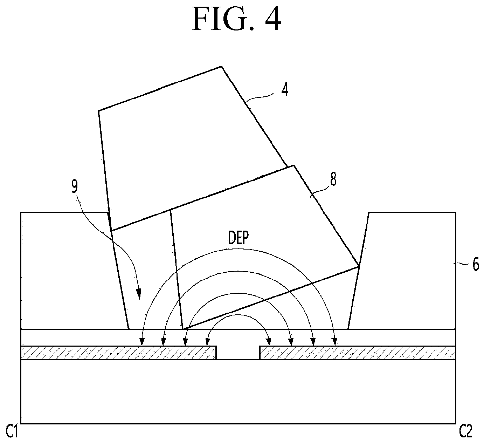

However, as illustrated in FIG. 4, when the DEP force is formed for self-assembly, a defect occurs in which two semiconductor light-emitting elements 4 and 8 are assembled.

That is, the auxiliary hole 9 is also formed by removing the partition wall 6 together with the assembly hole 7. As the partition wall 6 is removed, a DEP force having a size similar to that of the DEP force in the assembly hole 7 is also formed in the auxiliary hole 9. When the size of the DEP force in the assembly hole 7 is an optimized size for assembling the semiconductor light-emitting element 8 into the assembly hole 7, the DEP force formed in the auxiliary hole 9 is unnecessary. Accordingly, not only the semiconductor light-emitting element 8 suitable for the assembly hole 7, such as the red semiconductor light-emitting element, but also the semiconductor light-emitting element 4 suitable for another assembly hole, such as the blue semiconductor light-emitting element, are assembled, so that not only assembly defects but also color mixing defects occur. Here, color mixing defects mean that a semiconductor light-emitting element is assembled in an assembly hole where another semiconductor light-emitting element is assembled instead of the assembly hole where it is assembled, and thus a different color light is emitted from the subpixel comprising the assembly hole instead of the desired color light.

Meanwhile, a method of securing a deposition margin by removing a partition wall has been proposed to prevent a disconnection defect. However, there is a problem that the ashing process to remove the partition wall takes too long.

### [Disclosure]

### [Technical Problem]

An object of the embodiment is to solve the foregoing and other problems.

Another object of the embodiment is to provide a display device capable of preventing a disconnection defect of a connecting electrode (lateral electrode).

Another object of the embodiment is to provide a display device capable of preventing assembly defects or color mixing defects of two semiconductor light-emitting elements.

Another object of the embodiment is to provide a display device capable of shortening the process time and reducing the number of processes.

The technical problems of the embodiments are not limited to those described in this item and comprise those that may be understood through the description of the invention.

### [Technical Solution]

According to one aspect of the embodiment to achieve the above or other purposes, a display device, comprising: a substrate; a first assembly wiring and a second assembly wiring on the substrate; a partition wall disposed on the first assembly wiring and the second assembly wiring and having an assembly hole and at least one or more auxiliary hole that extends in an outer direction of the assembly hole; a semiconductor light-emitting element in the assembly hole; and a connecting electrode configured to be connected to a lateral part of the semiconductor light-emitting element, wherein the partition wall comprises: a first partition-wall layer; and a second partition-wall layer on the first partition-wall layer, and wherein an ashing rate of the first partition-wall layer is equal to or greater than an ashing rate of the second partition-wall layer.

A viscosity of the first partition-wall layer may be equal to or smaller than a viscosity of the second partition-wall layer.

A thickness of the second partition-wall layer may be equal to or smaller than a thickness of the first partition-wall layer.

The auxiliary hole may be formed by removing the first partition-wall layer or the second partition-wall layer.

The connecting electrode may be disposed in the assembly hole and the auxiliary hole.

A length of the auxiliary hole is smaller than a width of the first assembly wiring or the second assembly wiring.

The auxiliary hole may comprise: at least one or more first auxiliary hole on the first assembly wiring; and at least one or more second auxiliary hole on the second assembly wiring.

The first auxiliary hole and the second auxiliary hole may be positioned symmetrically to each other.

The partition wall may comprise the assembly hole and has an expansion hole that has a second diameter greater than a first diameter of the assembly hole, and the connecting electrode may be disposed between an outer side of the semiconductor light-emitting element and an inner side of the expansion hole.

The second diameter of the expansion hole may be 2 micrometers or more greater than the first diameter of the assembly hole.

The expansion hole may be formed by removing the first partition-wall layer.

The auxiliary hole may extend in the outer direction of the expansion hole.

The first partition-wall layer and the second partition-wall layer may each comprise an organic material.

A thickness of the partition wall may be smaller than a thickness of the semiconductor light-emitting element.

### [Advantageous Effects]

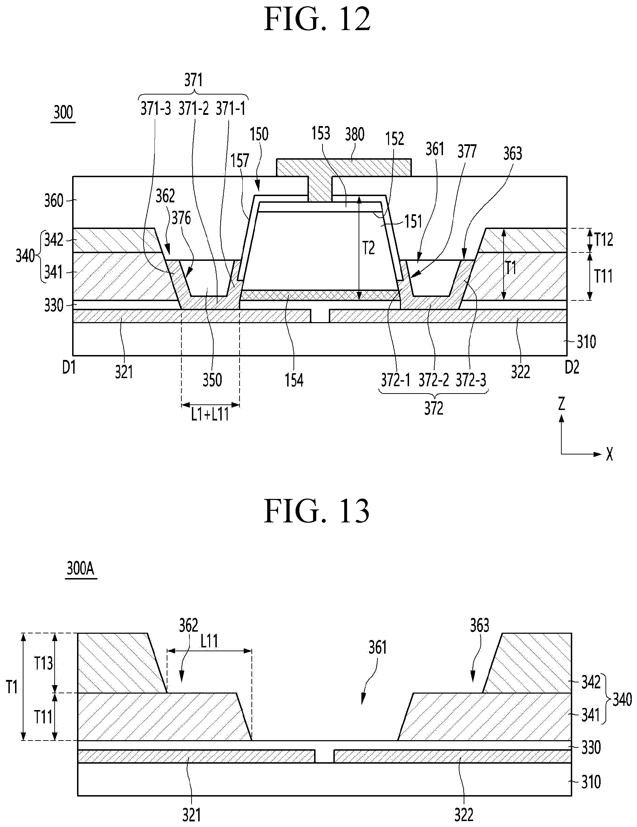

In the embodiment, as illustrated in FIG. 13, a backplane substrate 300A before performing self-assembly may have a part of the partition wall 340, for example, a first partition-wall layer 341, formed in auxiliary holes 362 and 363 extending laterally from an assembly hole 361. At this time, the ashing rate of the first partition-wall layer 341 may be greater than the ashing rate of a second partition-wall layer 342 of the partition wall 340. This may mean that the viscosity of the first partition-wall layer 341 is smaller than the viscosity of the second partition-wall layer 342.

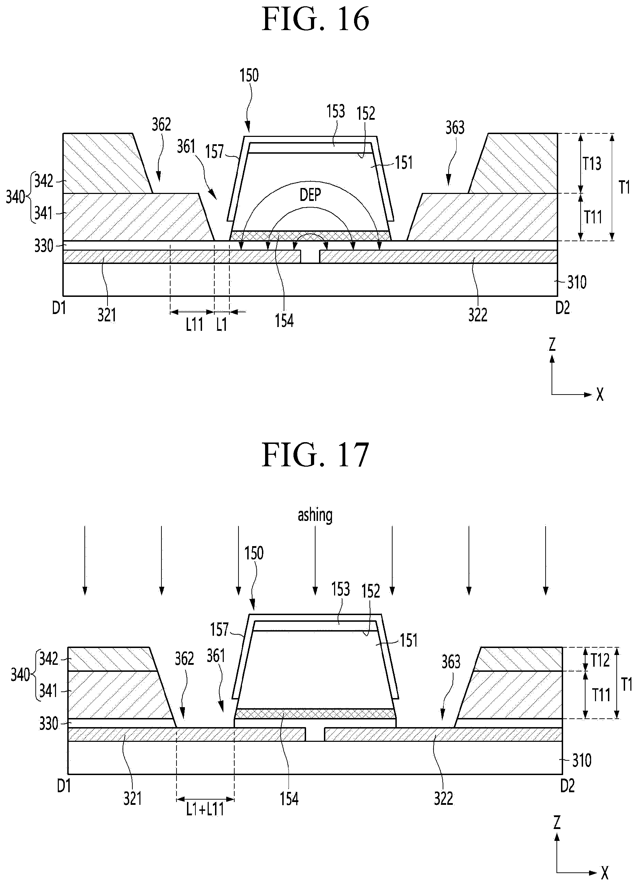

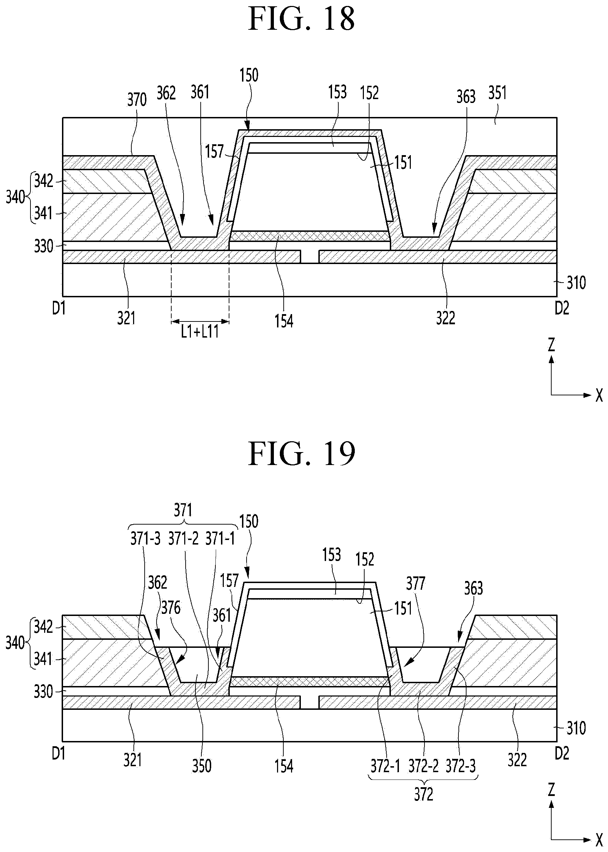

After the semiconductor light-emitting element 150 is assembled by performing a self-assembly process on the backplane substrate 300A (FIG. 16), an ashing process may be performed to remove the first partition-wall layer 341 in the auxiliary holes 362 and 363, so that sufficient space margin may be secured on a lateral part of the semiconductor light-emitting element 150. Accordingly, as illustrated in FIG. 18, even if a metal film 370 is deposited on a substrate 310, sufficient space margin corresponding to at least the sizes of the respective auxiliary holes 362 and 363 may be secured, so that the film quality of the metal film 370 can be improved. Thereafter, even if the metal film 370 is patterned to form the connecting electrodes 371 and 372 (FIG. 19), since no disconnection occurs in the connecting electrodes, lighting defects can be prevented, thereby improving the yield and enhancing reliability.

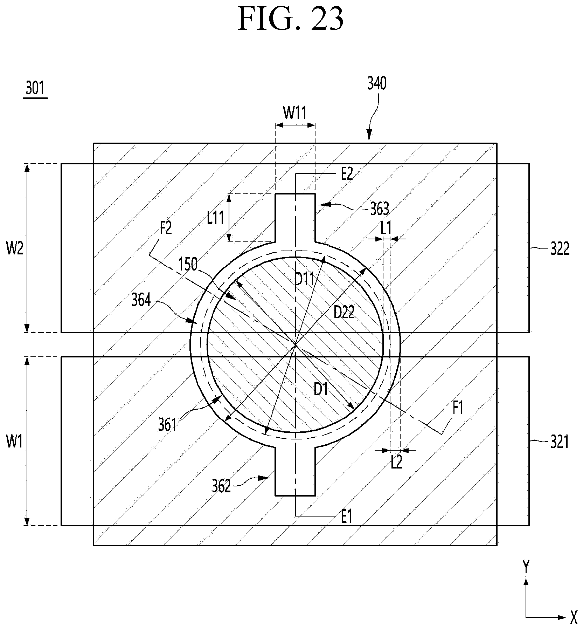

Meanwhile, as illustrated in FIG. 23, the semiconductor light-emitting element 150 may be assembled using the backplane substrate 300C, which comprises the assembly hole 361 and an expansion hole 364, and in which a part of the partition wall 340, that is, the first partition-wall layer 341, is formed in the expansion hole 364. Thereafter, the first partition-wall layer 341 on the expansion hole 364 may be removed using an ashing process, and a sufficient space margin may be secured along the perimeter of the semiconductor light-emitting element 150 in the expansion hole 364, and the connecting electrode may be disposed in this region. Thus, the connecting electrode may be disposed along the perimeter of the semiconductor light-emitting element 150 without disconnection, so that smoother current flow can enable high-luminance display.

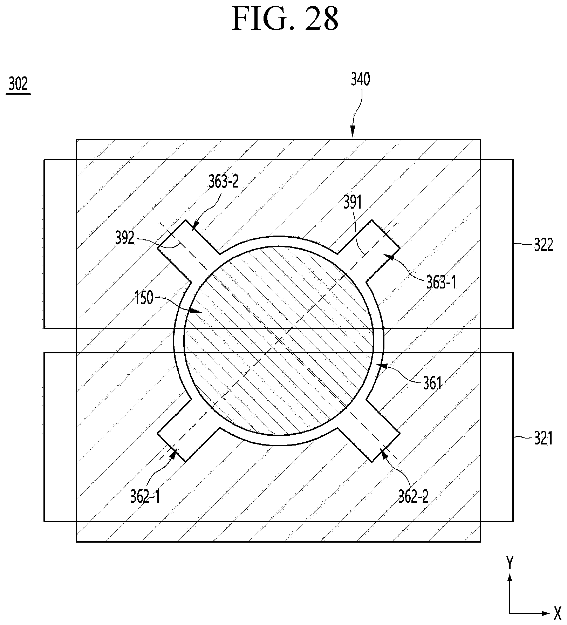

Meanwhile, as illustrated in FIG. 28, a plurality of auxiliary holes 362-1, 362-2, 363-1 and 363-2 may be provided, and connecting electrodes may be disposed in the plurality of auxiliary holes 362-1, 362-2, 363-1 and 363-2, so that a further improved high-luminance display may be implemented.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view illustrating a semiconductor light-emitting element disposed in an assembly hole in a non-public internal technology.
FIG. 2 is a cross-sectional view showing a disconnection defect of a lateral electrode connected to a lateral part of the light-emitting element illustrated in FIG. 1.
FIG. 3 is a plan view illustrating an auxiliary hole provided to prevent a disconnection defect.
FIG. 4 is a cross-sectional view illustrating the assembly of two semiconductor light-emitting elements due to an unnecessarily increased DEP force.
FIG. 5 illustrates a living room of a house in which a display device according to an embodiment is disposed.
FIG. 6 is a block diagram schematically showing a display device according to an embodiment.
FIG. 7 is a circuit diagram showing an example of a pixel of FIG. 6.
FIG. 8 is an enlarged view of a first panel region in the display device of FIG. 5.
FIG. 9 is an enlarged view of a region A2 of FIG. 8.
FIG. 10 is a drawing illustrating an example of assembling a light-emitting element according to an embodiment to a substrate by a self-assembly method.
FIG. 11 is a plan view illustrating a display device according to a first embodiment.
FIG. 12 is a cross-sectional view illustrating a display device according to the first embodiment.
FIG. 13 is a cross-sectional view illustrating a backplane substrate according to the first embodiment.
FIG. 14 is a schematic diagram illustrating a process of manufacturing a display device using a backplane substrate according to the first embodiment.
FIG. 15 illustrates a formation of auxiliary holes during the process of manufacturing a display device using a backplane substrate according to the first embodiment.
FIGS. 16 to 20 illustrate a process of manufacturing a display device using a backplane substrate according to the first embodiment.
FIG. 21 is a cross-sectional view illustrating a backplane substrate according to a second embodiment.
FIG. 22 illustrates a state in which an ashing process is performed after a semiconductor light-emitting element is assembled on a backplane substrate according to the second embodiment.
FIG. 23 is a plan view illustrating a display device according to the second embodiment.
FIG. 24 is a cross-sectional view taken along line E1-E2 of the display device according to the second embodiment.
FIG. 25 is a cross-sectional view taken along line F1-F2 of the display device according to the second embodiment.
FIGS. 26 and 27 are cross-sectional views illustrating a backplane substrate according to a third embodiment.
FIG. 28 is a plan view illustrating a display device according to the third embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for a display, a display for VR, AR or mixed reality (MR), a light source, etc. However, the configuration according to the embodiment described in this specification may be equally applied to a device capable of displaying, even if it is a new product type developed in the future.

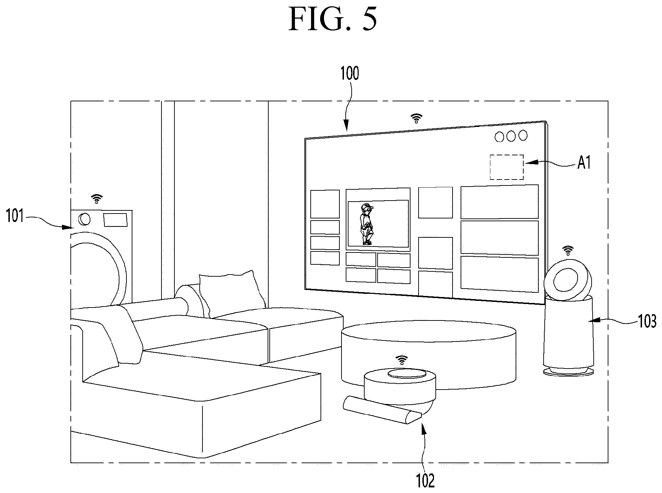

FIG. 5 illustrates a living room of a house in which a display device according to an embodiment is disposed.

Referring to FIG. 5, the display device 100 according to the embodiment may display the status of various electronic products such as a washing machine 101, a robot vacuum cleaner 102, an air purifier 103, etc., may communicate with each electronic product based on IoT, and may also control each electronic product based on user setting data.

The display device 100 according to the embodiment may comprise a flexible display manufactured on a thin and flexible substrate. The flexible display may be bent or rolled like paper while maintaining the characteristics of an existing flat display.

In a flexible display, visual information may be implemented by independently controlling the light emission of unit pixels disposed in a matrix form. A unit pixel means a minimum unit for implementing one color. The unit pixel of the flexible display may be implemented by a light-emitting element. In an embodiment, the light-emitting element may be a micro-LED or a nano-LED, but is not limited thereto.

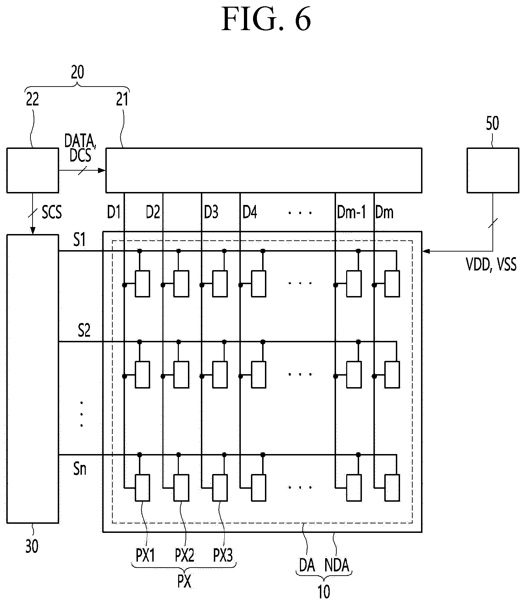

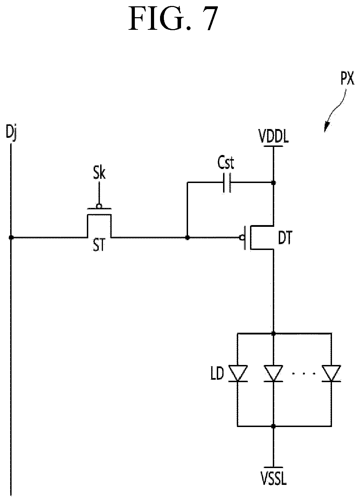

FIG. 6 is a block diagram schematically showing a display device according to an embodiment, and FIG. 7 is a circuit diagram showing an example of a pixel of FIG. 6.

Referring to FIG. 6 and FIG. 7, the display device according to an embodiment may comprise a display panel 10, a driving circuit 20, a scan driving unit 30, and a power supply circuit 50.

The display device 100 of the embodiment may drive a light-emitting element in an active matrix (AM) manner or a passive matrix (PM) manner.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on an upper surface of the substrate, and the non-display region NDA may be defined on a lower surface of the substrate. For example, the non-display region NDA may be defined on an entire region or a part of the lower surface of the substrate.

Meanwhile, although the drawing illustrates that the display region DA and the non-display region NDA are divided, the display region DA and the non-display region NDA may not be divided. That is, only the display region DA may exist on the upper surface of the substrate, and the non-display region NDA may not exist. In other words, an entire region of the upper surface of the substrate may be the display region DA where the image is displayed, and a bezel region, which is the non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but the present invention is not limited thereto. In addition, although FIG. 6 exemplifies that each of the pixels PX comprises three subpixels, the present invention is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD, a plurality of transistors for supplying current to the light-emitting elements LD, and at least one capacitor Cst, as shown in FIG. 7.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as shown in FIG. 7. The driving transistor DT may comprise a gate electrode connected to a source electrode of the scan transistor ST, a source electrode connected to a high-potential voltage line VDDL to which a high-potential voltage is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed of a thin film transistor. In addition, in FIG. 7, the driving transistor DT and the scan transistor ST are described mainly as being formed as P-type metal oxide semiconductor field effect transistors (MOSFETs), but the present invention is not limited thereto. The driving transistor DT and the scan transistor ST may also be formed as N-type MOSFETs. In this instance, the positions of the source electrode and the drain electrode of each of the driving transistor DT and the scan transistor STs may be changed.

In addition, in FIG. 7, the first subpixel PX1, the second subpixel PX2, and the third subpixel PX3 are exemplified as comprising 2T1C (2 Transistor - 1 capacitor) having one driving transistor DT, one scan transistor ST, and one capacitor Cst, but the present invention is not limited thereto. The first subpixel PX1, the second subpixel PX2, and the third subpixel PX3 may each comprise a plurality of scan transistors STs and a plurality of capacitors Cst.

The second subpixel PX2 and the third subpixel PX3 may be expressed by substantially the same circuit diagram as the first subpixel PX1, so that a detailed description thereof is omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts the digital video data DATA into analog data voltages according to the source control signal DCS and supplies them to the data lines D1 to Dm of the display panel 10.

The timing control unit 22 receives digital video data DATA and timing signals from the host system. The timing signals may comprise a vertical synchronization signal, a horizontal synchronization signal, a data enable signal, and a dot clock. The host system may be an application processor of a smartphone or tablet PC, a monitor, a system on chip of a TV, etc.

The timing control unit 22 generates control signals for controlling an operation timing of the data driving unit 21 and the scan driving unit 30. The control signals may comprise a source control signal DCS for controlling an operation timing of the data driving unit 21 and a scan control signal SCS for controlling an operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on the circuit board.

The scan driving unit 30 receives a scan control signal SCS from the timing control unit 22. The scan driving unit 30 generates scan signals according to the scan control signal SCS and supplies them to the scan lines S1 to Sn of the display panel 10. The scan driving unit 30 may comprise a plurality of transistors and may be formed in a non-display region NDA of the display panel 10. Alternatively, the scan driving unit 30 may be formed as an integrated circuit, in which case it may be mounted on a gate flexible film attached to the other side of the display panel 10.

The circuit board may be attached to pads provided on one edge of the display panel 10 using an anisotropic conductive film. As a result, lead lines of the circuit board may be electrically connected to the pads. The circuit board may be a flexible film such as a flexible printed circuit board, a printed circuit board, or a chip on film. The circuit board may be bent to a lower part of the display panel 10. As a result, one side of the circuit board may be attached to one edge of the display panel 10, and the other side may be disposed on the lower part of the display panel 10 and connected to a system board on which a host system is mounted.

The power supply circuit 50 may generate voltages required for driving the display panel 10 from a main power applied from the system board and supply the voltages to the display panel 10. For example, the power supply circuit 50 may generate a high-potential voltage VDD and a low-potential voltage VSS for driving the light-emitting elements LD of the display panel 10 from the main power supply and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power supply.

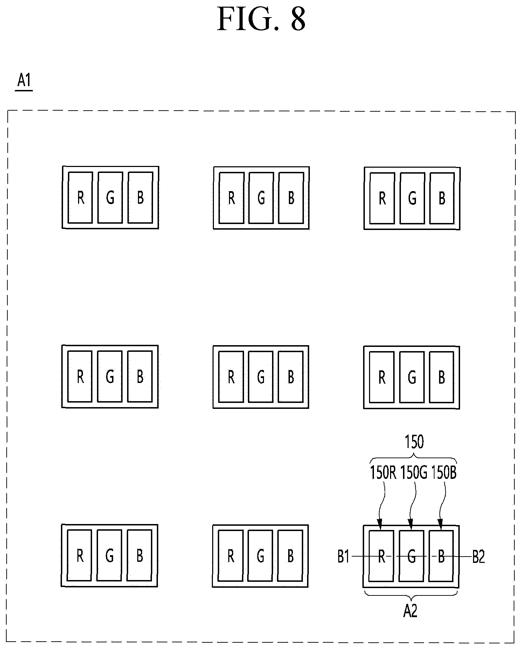

FIG. 8 is an enlarged view of a first panel region in the display device of FIG. 5.

Referring to FIG. 8, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 6).

For example, the unit pixel PX may comprise a first subpixel PX1, a second subpixel PX2, and a third subpixel PX3. For example, a plurality of red semiconductor light-emitting elements 150R may be disposed in the first subpixel PX1, a plurality of green semiconductor light-emitting elements 150G may be disposed in the second subpixel PX2, and a plurality of blue semiconductor light-emitting elements 150B may be disposed in the third subpixel PX3. The unit pixel PX may further comprise a fourth subpixel in which no semiconductor light-emitting elements are disposed, but is not limited thereto.

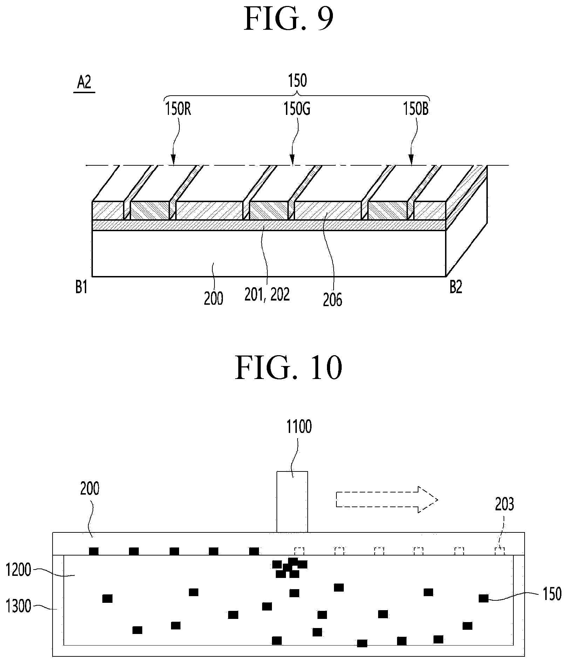

FIG. 9 is an enlarged view of a region A2 of FIG. 8.

Referring to FIG. 9, the display device 100 of the embodiment may comprise a substrate 200, assembly wirings 201 and 202, an insulating layer 206, and a plurality of semiconductor light-emitting elements 150. More components may be included than these.

The assembly wirings may comprise a first assembly wiring 201 and a second assembly wiring 202 that are spaced apart from each other. The first assembly wiring 201 and the second assembly wiring 202 may be provided to generate a dielectrophoretic force (DEP) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise a red semiconductor light-emitting element 150, a green semiconductor light-emitting element 150G, and a blue semiconductor light-emitting element 150B to form a unit pixel (subpixel), but is not limited thereto, and may also comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a support substrate in a display panel, and may also function as an assembly substrate when self-assembling a light-emitting element.

The substrate 200 may be a backplane equipped with circuits, such as transistors ST and DT, capacitor Cst, signal wiring, etc., within each of the subpixels PX1, PX2, and PX3 illustrated in FIGS. 6 and 7, but is not limited thereto.

The insulating layer 206 may comprise an insulating and flexible organic material such as polyimide, PAC, PEN, PET, polymer, etc., or an inorganic material such as silicon oxide (SiO₂) or silicon nitride series (SiNx), and may be formed integrally with the substrate 200 to form a single substrate.

The insulating layer 206 may be a conductive adhesive layer having adhesiveness and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a vertical direction relative to the thickness, but electrically insulating in a horizontal direction relative to the thickness.

The insulating layer 206 may comprise an assembly hole 203 for inserting the semiconductor light-emitting element 150. Therefore, during self-assembly, the semiconductor light-emitting element 150 may be easily inserted into the assembly hole 203 of the insulating layer 206. The assembly hole 203 may be called an insertion hole, a fixing hole, an alignment hole, etc. The assembly hole 203 may be called a hole.

The assembly hole 203 may be called a hole, a groove, a recess, a pocket, etc.

The assembly hole 203 may be different depending on a shape of the semiconductor light-emitting element 150. For example, the red semiconductor light-emitting element, the green semiconductor light-emitting element, and the blue semiconductor light-emitting element may have different shapes, and may have an assembly hole 203 having a shape corresponding to each shape of the semiconductor light-emitting elements. For example, the assembly hole 203 may comprise a first assembly hole for assembling the red semiconductor light-emitting element, a second assembly hole for assembling the green semiconductor light-emitting element, and a third assembly hole for assembling the blue semiconductor light-emitting element. For example, the red semiconductor light-emitting element may have a circular shape, the green semiconductor light-emitting element may have a first oval shape having a first minor axis and a first major axis, and the blue semiconductor light-emitting element may have a second oval shape having a second minor axis and a second major axis, but is not limited thereto. The second major axis of the oval shape of the blue semiconductor light-emitting element may be longer than the first major axis of the oval shape of the green semiconductor light-emitting element, and the second minor axis of the oval shape of the blue semiconductor light-emitting element may be shorter than the first minor axis of the oval shape of the green semiconductor light-emitting element.

Meanwhile, the method of mounting the semiconductor light-emitting element 150 on the substrate 200 may comprise, for example, a self-assembly method (FIG. 10) and a transfer method.

FIG. 10 is a drawing illustrating an example of assembling a light-emitting element according to an embodiment to a substrate by a self-assembly method.

Based on FIG. 10, an example of assembling a semiconductor light-emitting element according to an embodiment onto a display panel by a self-assembly method using an electromagnetic field will be described.

The assembly substrate 200 described below may also function as a panel substrate in a display device after assembling the light-emitting element, but the embodiment is not limited thereto.

Referring to FIG. 10, the semiconductor light-emitting element 150 may be put into a chamber 1300 filled with a fluid 1200, and the semiconductor light-emitting element 150 may be moved to the assembly substrate 200 by a magnetic field generated from the assembly device 1100. At this time, the semiconductor light-emitting element 150 adjacent to the assembly hole 207H of the assembly substrate 200 may be assembled into the assembly hole 207H by the DEP force caused by an electric field of the assembly wirings. The fluid 1200 may be water such as ultrapure water, but is not limited thereto. The chamber may be called a tank, a container, a vessel, etc.

After the semiconductor light-emitting element 150 is put into the chamber 1300, the assembly substrate 200 may be disposed on the chamber 1300. According to an embodiment, the assembly substrate 200 may also be put into the chamber 1300.

The semiconductor light-emitting element 150 may be implemented as a vertical-type semiconductor light-emitting element as illustrated, but is not limited thereto, and a lateral-type light-emitting element may be employed.

The semiconductor light-emitting element 150 may comprise a magnetic layer (not illustrated) having a magnetic substance. The magnetic layer may comprise a metal having magnetism, such as nickel (Ni). Since the semiconductor light-emitting element 150 put into the fluid comprises a magnetic layer, it may move to the assembly substrate 200 by a magnetic field generated from the assembly device 1100. The magnetic layer may be disposed on the upper side, the lower side or both sides of the light-emitting element.

The assembly substrate 200 may comprise a pair of first assembly wirings 201 and second assembly wirings 202 corresponding to each of the semiconductor light-emitting elements 150 to be assembled. Each of the first assembly wiring 201 and the second assembly wiring 202 may be formed by laminating a single metal or a metal alloy, a metal oxide, etc. in multiple layers. For example, each of the first assembly wiring 201 and the second assembly wiring 202 may be formed by comprising at least one of Cu, Ag, Ni, Cr, Ti, Al, Rh, Pd, Ir, Ru, Mg, Zn, Pt, Au, and Hf, but is not limited thereto.

The first assembly wiring 201 and the second assembly wiring 202 form an electric field when an AC voltage is applied, and the semiconductor light-emitting element 150 put into the assembly hole 207H may be fixed by the DEP force caused by the electric field. A gap between the first assembly wiring 201 and the second assembly wiring 202 may be smaller than a width of the semiconductor light-emitting element 150 and a width of the assembly hole 207H, and the assembly position of the semiconductor light-emitting element 150 may be fixed more precisely using the electric field.

An insulating layer 215 is formed on the first assembly wiring 201 and the second assembly wiring 202, so that the first assembly wiring 201 and the second assembly wiring 202 can be protected from the fluid 1200, and leakage of current flowing through the first assembly wiring 201 and the second assembly wiring 202 can be prevented. For example, the insulating layer 215 may be formed as a single layer or multiple layers of an inorganic insulator such as silica or alumina or an organic insulator. The insulating layer 215 may have a minimum thickness to prevent damage to the first assembly wiring 201 and the second assembly wiring 202 during assembly of the semiconductor light-emitting element 150, and may have a maximum thickness to stably assemble the semiconductor light-emitting element 150.

A partition wall 207 may be formed on an upper part of the insulating layer 215. A part of the partition wall 207 may be positioned at the upper parts of the first assembly wiring 201 and the second assembly wiring 202, and the remaining regions may be positioned at the upper part of the assembly substrate 200.

Meanwhile, when manufacturing the assembly substrate 200, a part of the partition wall formed on the upper part of the insulating layer 215 may be removed, thereby forming assembly holes 207H in which each of the semiconductor light-emitting elements 150 is coupled and assembled to the assembly substrate 200.

The assembly substrate 200 has assembly holes 207H formed in which the semiconductor light-emitting elements 150 are coupled, and a surface on which the assembly holes 207H are formed may be in contact with the fluid 1200. The assembly holes 207H may guide the exact assembly positions of the semiconductor light-emitting elements 150.

Meanwhile, the assembly holes 207H may have shapes and sizes corresponding to the shapes of the semiconductor light-emitting elements 150 to be assembled at the corresponding positions. Accordingly, it is possible to prevent another semiconductor light-emitting element from being assembled in the assembly hole 207H or a plurality of semiconductor light-emitting elements from being assembled.

Referring again to FIG. 10, after the assembly substrate 200 is disposed in the chamber, the assembly device 1100 applying a magnetic field may move along the assembly substrate 200. The assembly device 1100 may be a permanent magnet or an electromagnet.

The assembly device 1100 may move in contact with the assembly substrate 200 in order to maximize a region affected by the magnetic field within the fluid 1200. Depending on the embodiment, the assembly device 1100 may comprise a plurality of magnetic substances or may comprise a magnetic substance of a size corresponding to the assembly substrate 200. In this instance, the movement distance of the assembly device 1100 may be limited within a predetermined range.

The semiconductor light-emitting element 150 in the chamber 1300 may move toward the assembly device 1100 and the assembly substrate 200 by the magnetic field generated by the assembly device 1100.

The semiconductor light-emitting element 150 may be fixed by entering the assembly hole 207H by the DEP force formed by the electric field between the assembly wirings 201 and 202 while moving toward the assembly device 1100.

Specifically, the first and second assembly wirings 201 and 202 form an electric field by an AC power source, and the DEP force may be formed between the assembly wirings 201 and 202 by the electric field. The semiconductor light-emitting element 150 may be fixed to the assembly hole 207H on the assembly substrate 200 by the DEP force.

At this time, a predetermined solder layer (not illustrated) is formed between the semiconductor light-emitting element 150 assembled on the assembly hole 207H of the assembly substrate 200 and the assembly wirings 201 and 202 to improve the bonding strength of the semiconductor light-emitting element 150.

In addition, a molding layer (not illustrated) may be formed on the assembly hole 207H of the assembly substrate 200 after assembly. The molding layer may be a transparent resin or a resin containing a reflective material or a scattering material.

By the self-assembly method using the electromagnetic field described above, the time required for each semiconductor light-emitting element to be assembled on the substrate may be drastically shortened, so that a large-area, high-pixel display may be implemented more quickly and economically.

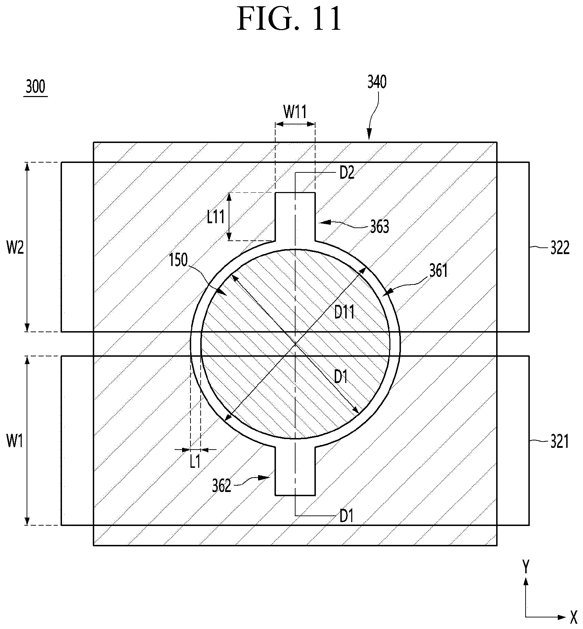

Hereinafter, various embodiments for solving the above-described problem will be described with reference to FIGS. 11 to 28. The omitted description below may be easily understood from the descriptions given above with respect to FIGS. 1 to 10 and the corresponding drawings.

### [First Embodiment]

FIG. 11 is a plan view illustrating a display device according to a first embodiment. FIG. 12 is a cross-sectional view illustrating a display device according to the first embodiment.

Referring to FIGS. 11 and 12, the display device 300 according to the first embodiment may comprise a substrate 310, a first assembly wiring 321, a second assembly wiring 322, a partition wall 340, a semiconductor light-emitting element 150, and connecting electrodes 371 and 372.

The substrate 310 may be a support member that supports components disposed on the substrate 310 or a protective member that protects the components.

The first assembly substrate 321 and the second assembly wiring 322 may be disposed on the substrate 310, respectively. For example, the first assembly substrate 321 and the second assembly wiring 322 may be disposed on the same layer, respectively. For example, the first and second assembly wirings 321 and 322 may be in contact with an upper surface of the substrate 310, but is not limited thereto. For example, the first assembly substrate 321 and the second assembly wiring 322 may be disposed on the same layer, respectively. For example, the first assembly substrate 321 and the second assembly wiring 322 may be disposed parallel to each other, respectively. The first assembly substrate 321 and the second assembly wiring 322 may each play a role in assembling the semiconductor light-emitting element 150 into the assembly hole 361 in a self-assembly manner. That is, an electric field may be generated between the first assembly wiring 321 and the second assembly wiring 322 by a voltage supplied to the first and second assembly wirings 321 and 322 during self-assembly, and the semiconductor light-emitting element 150 moving by the assembly device (1100 of FIG. 10) may be assembled into the assembly hole 361 by the DEP force formed by the electric field. The assembly hole 361 may have a diameter D11 greater than a diameter D1 of the semiconductor light-emitting element.

Although not illustrated, the first assembly wiring 321 and the second assembly wiring 322 may be disposed on different layers.

The partition wall 340 may be disposed on the first and second assembly wirings 321 and 322. The partition wall 340 may have an assembly hole 361 and auxiliary holes 362 and 363 for assembling the semiconductor light-emitting element 150. For example, a first insulating layer 330 may be exposed within the assembly hole 361 and the auxiliary holes 362 and 363. For example, a bottom surface of the assembly hole 361 may be an upper surface of the first insulating layer 330. The auxiliary holes 362 and 363 may extend in an outward direction of the assembly hole 361.

A thickness of the partition wall 340 may be determined in consideration of a thickness T2 of the semiconductor light-emitting element 150. For example, the thickness T1 of the partition wall 340 may be smaller than the thickness T2 of the semiconductor light-emitting element 150. Accordingly, an upper side of the semiconductor light-emitting element 150 may be positioned higher than an upper surface of the partition wall 340. That is, the upper side of the semiconductor light-emitting element 150 may protrude upward from the upper surface of the partition wall 340.

A size of the assembly hole 361 may be determined by considering a tolerance margin for forming the assembly hole 361 and a margin for easily assembling the semiconductor light-emitting element 150 within the assembly hole 361. For example, the size of the assembly hole 361 may be greater than a size of the semiconductor light-emitting element 150. For example, when the semiconductor light-emitting element 150 is assembled at the center of the assembly hole 361, a distance between the outer side of the semiconductor light-emitting element 150 and the inner side of the assembly hole 361 may be 2*µ*m or less, but is not limited thereto. For example, when the semiconductor light-emitting element 150 is assembled at the center of the assembly hole 361, a gap L1 between the outer side of the semiconductor light-emitting element 150 and the inner side of the assembly hole 361 may be 1.5*µ*m or less.

For example, the assembly hole 361 may have a shape corresponding to the shape of the semiconductor light-emitting element 150. For example, when the semiconductor light-emitting element 150 is circular, the assembly hole 361 may also be circular. For example, when the semiconductor light-emitting element 150 is rectangular, the assembly hole 361 may also be rectangular.

The partition wall 340 may have at least one or more auxiliary hole 362 and 363 extending in a lateral direction of the assembly hole 361.

For example, the auxiliary holes may comprise a first auxiliary hole 362 formed on the first assembly wiring 321 and a second auxiliary hole 363 formed on the second assembly wiring 322. For example, the first auxiliary hole 362 and the second auxiliary hole 363 may be disposed along the Y direction. For example, the first auxiliary hole 362 may be formed by extending from the assembly hole 361 in the (-) Y direction, and the second auxiliary hole 363 may be formed by extending from the assembly hole 361 in the (+) Y direction.

The first auxiliary hole 362 and the second auxiliary hole 363 may be positioned symmetrically to each other. For example, as illustrated in FIG. 11, the first auxiliary hole 362 may be positioned from the assembly hole 361 in the (-) Y direction, that is, in a direction vertically crossing the first assembly wiring, and the second auxiliary hole 363 may be positioned from the assembly hole 361 in the (+) Y direction, that is, in a direction vertically crossing the second assembly wiring.

Meanwhile, the auxiliary holes 362 and 363 may have sufficient space so that a metal film for forming the connecting electrodes 371 and 372 may be deposited continuously without interruption. For example, the auxiliary holes 362 and 363 may have the same width W11 and length L11, but is not limited thereto. For example, the width W11 may be 2 *µ*m to 4 *µ*m. For example, the length L11 may be 2 *µ*m to 4 *µ*m. When the width W11 or the length L11 is less than 2 *µ*m, the space between the auxiliary holes 362 and 363 may be narrow, which may cause an interruption in the metal film. When the width W11 or the length L11 exceeds 4 *µ*m, the space may become large, which may cause another semiconductor light-emitting element to be attached to the auxiliary holes 362 and 363 during self-assembly. Thus, an assembly defect may occur and waste of semiconductor light-emitting elements may occur, which may increase manufacturing cost.

For example, the width W11 or the length L11 of the auxiliary holes 362 and 363 may be greater than the gap L1 between the outer side of the semiconductor light-emitting element 150 and the inner side of the assembly hole 361. Since the width W11 or the length L11 of the auxiliary holes 362 and 363 is greater than the gap L1 between the outer side of the semiconductor light-emitting element 150 and the inner side of the assembly hole 361, when a metal film is deposited on the auxiliary holes 362 and 363 to form the connecting electrodes 371 and 372, an electrical disconnection is not formed on the connecting electrodes 371 and 372, so that a lighting defect can be prevented.

For example, the length L11 of the auxiliary holes 362 and 363 may be smaller than the width W1 and W2 of the first assembly wiring 321 or the second assembly wiring 322. When the length L11 of the auxiliary holes 362 and 363 is greater than the widths W1 and W2 of the first assembly wiring 321 or the second assembly wiring 322, an electrical short may occur between the connecting electrodes 371 and 372 disposed in the auxiliary holes 362 and 363 and the first assembly wiring 321 and/or the second assembly wiring 322 disposed in the adjacent subpixels.

Meanwhile, as described above, an unnecessary DEP force may be increased by the auxiliary holes 362 and 363, which may cause assembly defects or color mixing defects due to two semiconductor light-emitting elements.

According to an embodiment, the partition wall 340 may be composed of a first partition-wall layer 341 and a second partition-wall layer 342, and the first partition-wall layer 341 may be disposed in the auxiliary holes 362 and 363 before self-assembly, so that assembly defects or color mixing defects due to unnecessary increase in DEP force during self-assembly can be prevented.

According to an embodiment, after the semiconductor light-emitting element 150 is assembled in the assembly hole 361 using a self-assembly process, the first partition-wall layer 341 in the auxiliary holes 362 and 363 may be removed, so that disconnection may not occur in the connecting electrodes 371 and 372 to be formed on the lateral part of the semiconductor light-emitting element 150 later.

The first partition-wall layer 341 in the auxiliary holes 362 and 363 may be removed using an ashing process. For example, the first partition-wall layer 341 and the second partition-wall layer 342 may be formed of organic materials having different viscosities. For example, the viscosity of the first partition-wall layer 341 may be equal to or less than the viscosity of the second partition-wall layer 342. For example, the first partition-wall layer 341 may have a viscosity of 10cp or less as HI-900. For example, the second partition-wall layer 342 may be approximately 90cp as JSR.

The viscosity and the ashing rate (or etching rate) may be inversely proportional. For example, the lower the viscosity, the higher the ashing rate. Accordingly, the ashing rate of the first partition-wall layer 341 may be equal to or greater than the ashing rate of the second partition-wall layer 342.

In the backplane substrate, the thickness of the second partition-wall layer 342 may be greater than the thickness of the first partition-wall layer 341. Thereafter, by performing an ashing process, the first partition-wall layer 341 in the auxiliary holes 362 and 363 may be removed, so that a sufficient margin space for electrical connection on a lateral part of the semiconductor light-emitting element 150 may be secured. Thereafter, by using a deposition process, connecting electrodes 371 and 372 may be formed on the lateral part of the semiconductor light-emitting element 150 through the auxiliary holes 362 and 363, so that disconnection defects of the connecting electrodes 371 and 372 can be prevented. A more detailed description will be given later.

Meanwhile, the thickness T1 of the partition wall 340 is made smaller than the thickness T2 of the semiconductor light-emitting element 150, so that the metal film formed by the connecting electrodes 371 and 372 may be more easily deposited in the gap L1 between the outer side of the semiconductor light-emitting element 150 and the inner side of the assembly hole 361, thereby reducing the disconnection defect of the connecting electrodes 371 and 372.

Meanwhile, the semiconductor light-emitting element 150 may be disposed in the assembly hole 361.

The semiconductor light-emitting element 150 may comprise a red semiconductor light-emitting element that generates red light, a green semiconductor light-emitting element that generates green light, and a blue semiconductor light-emitting element that generates blue light.

For example, during self-assembly, red semiconductor light-emitting elements, green semiconductor light-emitting elements, and blue semiconductor light-emitting elements distributed in the same chamber (1300 in FIG. 10) may be simultaneously moved by the same assembly device 1100 and assembled into the assembly holes 361 of the corresponding subpixels (PX1, PX2, PX3 in FIG. 9).

When the sizes of the assembly holes 361 of the subpixels (PX1, PX2, PX3 of FIG. 9) is the same, the red semiconductor light-emitting element, the green semiconductor light-emitting element, and the blue semiconductor light-emitting element may not be assembled into the assembly hole 361 into which they are to be assembled, but may be assembled into different assembly holes 361. To solve this problem, the shapes of the red semiconductor light-emitting element, the green semiconductor light-emitting element, and the blue semiconductor light-emitting element may be different, and the assembly holes 361 may be formed to correspond to the different shapes of the red semiconductor light-emitting element, the green semiconductor light-emitting element, and the blue semiconductor light-emitting element, respectively. That is, the exclusivity between the semiconductor light-emitting elements 150 may be increased, thereby preventing assembly defects or color mixing defects.

For example, the shape of the red semiconductor light-emitting element may be circular, the shape of the green semiconductor light-emitting element may be a first oval having a first minor axis and a first major axis, and the shape of the blue semiconductor light-emitting element may be a second oval having a second minor axis smaller than the first minor axis and a second major axis greater than the first major axis.

The semiconductor light-emitting element 150 may be disposed in the assembly hole 361 to generate colored light. As described above, the semiconductor light-emitting element 150 may comprise one of a red semiconductor light-emitting element, a green semiconductor light-emitting element, and a blue semiconductor light-emitting element. For example, the red semiconductor light-emitting element may be disposed in the first subpixel (PX1 of FIG. 9), the green semiconductor light-emitting element may be disposed in the second subpixel PX2, and the blue semiconductor light-emitting element may be disposed in the third subpixel PX3. Accordingly, a full-color image may be displayed by the red light emitted from the first subpixel PX1, the green light emitted from the second subpixel PX2, and the blue light emitted from the third subpixel PX3.

The semiconductor light-emitting element 150 of the embodiment may be a vertical-type semiconductor light-emitting element, but is not limited thereto. In this instance, after the semiconductor light-emitting element 150 is assembled in the assembly hole 361, an electrode 154 of the semiconductor light-emitting element 150 may be electrically connected to a lower electrode wiring, i.e., the first assembly wiring 321 or the second assembly wiring 322, and an upper side of the semiconductor light-emitting element 150 may be electrically connected to an electrode wiring 380.

Meanwhile, the semiconductor light-emitting element 150 may comprise a light-emitting part 151, 152, and 153, the electrode 154, and a passivation layer 157. The semiconductor light-emitting element 150 according to the first embodiment may comprise more components than these.

The light-emitting part 151, 152, and 153 comprise a first conductivity type semiconductor layer 151, an active layer 152, and a second conductivity type semiconductor layer 153, but more components may be included than these.

The first conductivity type semiconductor layer 151 may comprise a first conductive dopant, and the second conductivity type semiconductor layer 153 may comprise a second conductive dopant. For example, the first conductive dopant may be an n-type dopant such as silicon (Si), and the second conductive dopant may be a p-type dopant such as boron (B).

The electrode 154 may be disposed on a lower side of the first conductivity type semiconductor layer 151. The electrode 154 may comprise at least one or more layer. For example, the electrode 154 may comprise a bonding layer for bonding the semiconductor light-emitting element 150 to the substrate 310, and an adhesive layer for bonding the bonding layer to the lower side of the light-emitting part 151, 152, and 153, for example, the first conductivity type semiconductor layer 151. For example, the bonding layer may be made of indium (In), tin (Sn), etc. For example, the adhesive layer may be made of titanium (Ti), chromium (Cr), etc.

Although not illustrated, a second electrode may be disposed on the second conductivity type semiconductor layer 153. The second electrode may comprise at least one or more layer. The second electrode may comprise a transparent conductive layer and a magnetic layer. The transparent conductive layer may be made of a transparent conductive material, such as ITO. The transparent conductive layer may obtain a current spreading effect that allows current supplied from the electrode wiring 380 to evenly spread throughout an entire region of the second conductivity type semiconductor layer 153. That is, since the current is evenly spread throughout the entire region of the second conductivity type semiconductor layer 153 by the transparent conductive layer, holes may be generated throughout the entire region of the second conductivity type semiconductor layer 153. Thus, the amount of holes generated and increasing the amount of light generated by the recombination of holes and electrons in the active layer 152 may be increased, so that light efficiency can be increased. The increase in light efficiency may lead to an improvement in luminance.

The magnetic layer may comprise nickel (Ni), cobalt (Co), iron (Fe), etc. The magnetic layer may comprise SmCo, Gd-based, La-based, and Mn-based metals. The magnetic layer may be magnetized by a magnetic substance provided in an assembly device (Figure 1100) during self-assembly, and plays a role in causing the semiconductor light-emitting element 150 to act as an attractive force with the magnetic substance. Therefore, during self-assembly, the semiconductor light-emitting element 150 may move more quickly and rapidly according to the movement of the magnetic substance, thereby shortening the process time and improving the assembly yield.

The passivation layer 157 may protect the light-emitting part 151, 152, and 153.

The passivation layer 157 can prevent the semiconductor light-emitting element 150 from being turned over during self-assembly, and the lower side of the semiconductor light-emitting element 150, that is, the lower surface of the first conductive semiconductor layer 151, may face an upper surface of the first insulating layer 330. Accordingly, during self-assembly, the lower side of the semiconductor light-emitting element 150 may be positioned facing the first insulating layer 330, and the upper side of the semiconductor light-emitting element 150 may be positioned toward an upper direction, so that misalignment resulting from the semiconductor light emitting element 150 being assembled upside down can be prevented.

The connecting electrodes 371 and 372 may be disposed in the auxiliary holes 362 and 363 of the partition wall 340. The connecting electrodes 371 and 372 may be electrically connected to the lateral parts of the semiconductor light-emitting element 150 in the auxiliary holes 362 and 363 of the partition wall 340. Since the auxiliary holes 362 and 363 may be provided which are greater than the gap L1 between the outer side of the semiconductor light emitting element 150 and the inner side of the assembly hole 361, the connecting electrodes 371 and 372 may be formed through the auxiliary holes 362 and 363, so that no disconnection occurs in the connecting electrodes 371 and 372.

For example, the first sides of the connecting electrodes 371 and 372 may be electrically connected to the first assembly wiring 321 and/or the second assembly wiring 322 through the first insulating layer 330, and the second sides of the connecting electrodes 371 and 372 may be electrically connected to the lateral parts of the semiconductor light-emitting element 150.

For example, the connecting electrodes 371 and 372 may be formed of at least one or more layer having excellent electrical conductivity. For example, the connecting electrodes 371 and 372 may comprise a first layer comprising molybdenum (Mo), a second layer comprising aluminum (Al), and a third layer comprising molybdenum (Mo).

According to a non-public internal technology, the gap L1 between the inner side of the assembly hole 361 and the outer side of the semiconductor light-emitting element 150 is very narrow, and a metal film for forming the connecting electrodes 371 and 372 is deposited on a region having the narrow gap L1, so that the metal film is not continuously connected but is disconnected. Even if the metal film is patterned to form the connecting electrodes 371 and 372, an electrical disconnection occurs in a disconnected portion, resulting in a lighting defect.

However, according to an embodiment, the auxiliary holes 362 and 363 may be formed by extending laterally from the assembly hole 361 of the partition wall 340 in which the semiconductor light-emitting element 150 is assembled, and the connecting electrodes 371 and 372 may be disposed in the auxiliary holes 362 and 363, so that the connecting electrodes 371 and 372 may be electrically connected to the lateral parts of the semiconductor light-emitting element 150 without disconnection, thereby preventing lighting defect.

That is, the auxiliary holes 362 and 363 extended from the assembly hole 361 may be empty spaces in which the semiconductor light-emitting element 150 is not disposed. Accordingly, when a metal film is deposited on the partition wall 340 and the semiconductor light-emitting element 150 after the semiconductor light-emitting element 150 is assembled in the assembly hole 361, the metal film may be continuously connected without an interruption in regions between the inner sides of the auxiliary holes 362 and 363 and the outer side of the semiconductor light-emitting element 150 disposed in the assembly hole 361 since the gap L1 between the inner side of each of the auxiliary holes 362 and 363 and the outer side of the semiconductor light-emitting element 150 disposed in the assembly hole 361 may increase by at least an extension length L11 of each of the auxiliary holes 362 and 363. Accordingly, when the metal film is patterned to form the connecting electrodes 371 and 372, the connecting electrodes 371 and 372 may be electrically connected to the lateral parts of the semiconductor light-emitting element 150 without electrical disconnection, so that lighting defect can be prevented.

Meanwhile, the connecting electrode may comprise a first connecting electrode 371 disposed in the first auxiliary hole 362 and a second connecting electrode 372 disposed in the second auxiliary hole 363.

For example, the first connecting electrode 371 may be electrically connected to a first side 158a of the semiconductor light-emitting element 150 through the assembly hole 361 in the first auxiliary hole 362. For example, the second connecting electrode 372 may be electrically connected to a second side 158b of the semiconductor light-emitting element 150 through the assembly hole 361 in the second auxiliary hole 363.

In the embodiment, two connecting electrodes, i.e., the first and second connecting electrodes 371 and 372, may be electrically connected to lateral parts of the semiconductor light-emitting element 150, but only one connecting electrode among the first and second connecting electrodes 371 and 372 may be connected to a lateral part of the semiconductor light-emitting element 150, and the remaining connecting electrode may be omitted.

The first and second connecting electrodes 371 and 372 may comprise first connecting regions 371_1 and 372_1 that are in contact with the lateral parts of the semiconductor light-emitting element 150, second connecting regions 371_2 and 372_2 that extend from the first connecting regions 371_1 and 372_1 and are in contact with an upper surface of one of the first and second assembly wirings 321 and 322, and third connecting regions 371_3 and 372_3 that extend from the second connecting regions 371_2 and 372_2 and are in contact with the inner sides of the auxiliary holes 362 and 363.

The upper sides of the first connecting regions 371_1 and 372_1 may be in contact with the passivation layer 157 of the semiconductor light-emitting element 150, and the lower sides of the first connecting regions 371_1 and 372_1 may be in contact with the lateral surface of the first conductivity type semiconductor layer 151 of the semiconductor light-emitting element 150 and/or the lateral surface of the electrode 154.

The first connecting regions 371_1 and 372_1 and the third connecting regions 371_3 and 372_3 may have the same height, but is not limited thereto.

Meanwhile, although not illustrated, the connecting electrodes may be disposed along the perimeter of the semiconductor light-emitting element 150 within the assembly hole 361. For example, the connecting electrodes may be disposed between the inner side of the assembly hole 361 and the outer side of the semiconductor light-emitting element 150.

For example, a first side of the connecting electrode in the assembly hole 361 may be connected to the first connecting electrode 371 in the auxiliary holes 362 and 363, and a second side of the connecting electrode in the assembly hole 361 may be connected to the second connecting electrode 372 in the auxiliary holes 362 and 363.

Meanwhile, since the assembly hole 361 and the auxiliary holes 362 and 363 are in communication with each other, when a metal film is deposited to form the connecting electrodes 371 and 372, the deposited metal film may be formed continuously between the assembly hole 361 and the auxiliary holes 362 and 363. Accordingly, the connecting electrode in the assembly hole 361 may be connected to the first connecting electrode 371 and/or the second connecting electrode 372 through the auxiliary holes 362 and 363.

Therefore, the first connecting regions 371_1 and 372_1 may be in contact with the lateral parts of the semiconductor light-emitting element 150 along the perimeter of the semiconductor light-emitting element 150 in the assembly hole 361, and the second connecting regions 371_2 and 372_2 may be in contact with an upper surface of one of the first and second assembly wirings 321 and 322 along the perimeter of the semiconductor light-emitting element 150 in the auxiliary holes 362 and 363. In addition, the second connecting regions 371_2 and 372_2 in the assembly hole 361 may extend from the auxiliary holes 362 and 363 to the third connecting regions 371_3 and 372_3 to be in contact with an inner sides of the auxiliary holes 362 and 363.

According to an embodiment, the connecting electrodes 371 and 372 may be disposed not only in the assembly hole 361 but also in the auxiliary holes 362 and 363, and may be also attached to the lateral surfaces of the semiconductor light-emitting element 150, the upper surface of the first and/or second assembly wirings 321 and 322 through the first insulating layer 330, and the inner sides of the assembly hole 361 and the auxiliary holes 362 and 363, so that the bonding force of the semiconductor light-emitting element 150 can be strengthened and the reliability can be improved.

Meanwhile, the first connecting electrode 371 may have a first groove 376, and the second connecting electrode 372 may have a second groove 377. A thin metal film in a region in which space margin for deposition is sufficient may be deposited, so that the first groove 376 and the second groove 377 may be formed.

Meanwhile, the display device 300 according to the first embodiment may comprise a first insulating layer 330, a second insulating layer 350, a third insulating layer 360, and electrode wiring 380.

The first insulating layer 330 may be disposed on the substrate 310. For example, the first insulating layer 330 may be made of an inorganic material or an organic material. For example, the first insulating layer 330 may be made of a material having a permittivity related to the DEP force.

The second insulating layer 350 may be disposed in each of the first groove 376 and the second groove 377. As will be described later in the manufacturing process, the partition wall 340 may serve as a stopper that determines the height of the connecting electrodes 371 and 372. That is, the height of the connecting electrodes 371 and 372 may be formed as much as a height of the second insulating layer 350. That is, when the height of the second insulating layer 350 is increased, the height of the connecting electrodes 371 and 372 may also be increased.

The third insulating layer 360 may be disposed on the partition wall 340 and the second insulating layer 350. The third insulating layer 360 may be a planarizing layer for easily forming the electrode wiring 380 or other layers. Therefore, an upper surface of the third insulating layer 360 may have a flat surface. The first to third insulating layers 330, 350, and 360 may be made of an organic material or an inorganic material. For example, at least one or more insulating layer among the first to third insulating layers 330, 350, and 360 may be made of an organic material. For example, at least two of the first to third insulating layers 330, 350, and 360 may be made of the same material.

The electrode wiring 380 may be disposed on the third insulating layer 360 and may be electrically connected to the semiconductor light-emitting element 150 through the third insulating layer 360. For example, the electrode wiring 380 may be electrically connected to an upper side of the light-emitting part 151, 152, and 153 through the third insulating layer 360 and the passivation layer 157 of the semiconductor light-emitting element 150.

Accordingly, the semiconductor light-emitting element 150 may emit light by a voltage supplied to the first assembly wiring 321 and/or the second assembly wiring 322 and the electrode wiring 380.

According to the first embodiment, since the partition wall 340 comprises a first partition-wall layer 341 and a second partition-wall layer 342 having different ashing rates, before self-assembly, the first partition-wall layer 341 may be disposed in the auxiliary holes 362 and 363 to prevent assembly defects or color mixing defects, and after self-assembly, the first partition-wall layer 341 in the auxiliary holes 362 and 363 may be removed to prevent disconnection defects of the connecting electrodes 371 and 372.

According to the first embodiment, the connecting electrodes 371 and 372 may be disposed not only in the assembly hole 361 but also in the auxiliary holes 362 and 363, and may be also attached to the side surfaces of the semiconductor light-emitting element 150, the upper surface of the first and/or second assembly wirings 321 and 322 through the first insulating layer 330, and the inner sides of the assembly hole 361 and the auxiliary holes 362 and 363, so that the bonding force of the semiconductor light-emitting element 150 can be strengthened and the reliability can be improved.

Meanwhile, as described above, when the partition wall 340 in the auxiliary holes 362 and 363 are completely removed, two or more semiconductor light-emitting elements are assembled in the assembly hole 361 due to unnecessary DEP force formed in the auxiliary holes 362 and 363 during self-assembly, resulting in assembly defects or color mixing defects.

In the embodiment, by leaving a part of or removing all of the partition wall 340 in the auxiliary holes 362 and 363 before and after self-assembly, assembly defects or color mixing defects can be prevented. In addition, due to the space margin of the auxiliary holes 362 and 363, disconnection defects of the connecting electrodes 371 and 372 can also be prevented.

First, a backplane substrate 300A as illustrated in FIG. 13 may be prepared. The backplane substrate 300A may be a base substrate for manufacturing the display device 300 by performing a self-assembly process and a post-process such as electrical connection.

A backplane substrate 300A may be manufactured by forming a first assembly wiring 321 and/or a second assembly wiring 322, an insulating layer 330, an assembly hole 361, and a partition wall 340 having auxiliary holes 362 and 363 on a substrate 310.

The partition wall 340 may be formed with a first partition-wall layer 341 and a second partition-wall layer 342 on the first partition-wall layer 341. The first partition-wall layer 341 may not be formed in the assembly hole 361, but may be formed in the auxiliary holes 362 and 363. That is, the first partition-wall layer 341 may be formed on the substrate 310 excluding the assembly hole 361. The second partition-wall layer 342 may not be formed in the assembly hole 361 and the auxiliary holes 362 and 363. That is, the second partition-wall layer 342 may be formed on the substrate 310 excluding the assembly hole 361 and the auxiliary holes 362 and 363.

The first partition-wall layer 341 may not vertically overlap with the assembly hole 361, but may vertically overlap with the auxiliary holes 362 and 363. The second partition-wall layer 342 may not vertically overlap with the assembly hole 361 and the auxiliary holes 362 and 363, respectively.

The partition wall 340 may have a multi-stage structure having the first partition-wall layer 341 and the second partition-wall layer 342 when viewed in an outward direction from the assembly hole 361. That is, an end of the second partition-wall layer 342 may be positioned spaced outwardly from an end of the first partition-wall layer 341 in the auxiliary holes 362 and 363, so that the second partition-wall layer 342 may not vertically overlap the auxiliary holes 362 and 363.

Meanwhile, although not illustrated, a plurality of pixel circuits and a plurality of signal lines connected to the respective pixel circuits may be provided for a plurality of pixels on the backplane substrate 300A. The signal lines may comprise data lines D1 to Dm, scan lines S1 to Sn, high-potential voltage lines VDDL, low-potential voltage lines VSSL, etc. illustrated in FIGS. 6 and 7.

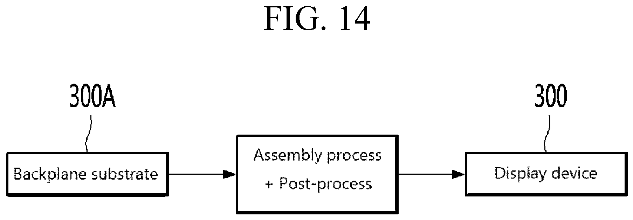

As illustrated in FIG. 14, a self-assembly process and a post-process are performed on the backplane substrate 300A, so that a display device 300 in which semiconductor light-emitting elements 150 are arranged and electrically connected to each pixel may be manufactured.

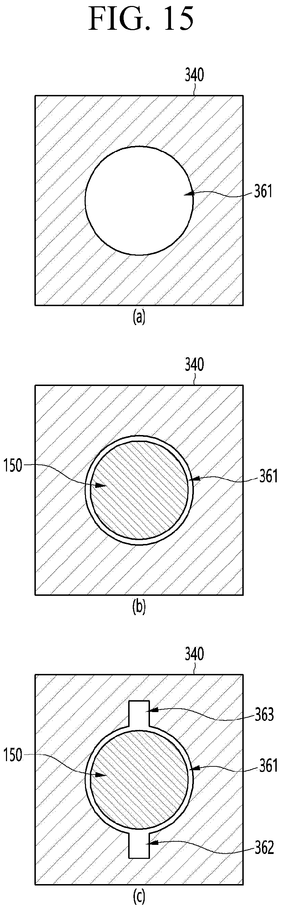

A backplane substrate 300A may be provided. As illustrated in FIG. 15(a), an assembly hole 361 may be provided on the backplane substrate 300A. As described above, the assembly hole 361 may be formed by the first partition-wall layer 341 and the second partition-wall layer 342 constituting the partition wall 340. That is, the first partition-wall layer 341 and the second partition-wall layer 342 may be removed from each of a plurality of pixels, thereby forming an assembly hole 361 in which the insulating layer 330 is exposed. As illustrated in FIG. 13, the first partition-wall layer 341 may be formed in the auxiliary holes 362 and 363, so that the auxiliary holes 362 and 363 in complete forms are not formed, and thus the auxiliary holes 362 and 363 are not illustrated in FIG. 15(a).

As illustrated in FIG. 15(b), an assembly process may be performed so that a semiconductor light-emitting element 150 may be assembled into an assembly hole 361. Thereafter, an ashing process may be performed so that the first partition-wall layer 341 in the auxiliary holes 362 and 363 may be removed, thereby exposing the insulating layer 330, so that a space margin on the lateral part of the semiconductor light-emitting element 150 may be secured.

As illustrated in FIG. 15(c), a deposition process may be performed so that a metal film is deposited in auxiliary holes 362 and 363 with sufficient space margin, so that no disconnection occurs at the connecting electrodes 371 and 372 formed by a subsequent patterning process, and thus lighting defects can be prevented.

FIGS. 16 to 20 illustrate a process of manufacturing a display device using a backplane substrate according to the first embodiment.

As illustrated in FIG. 16, a backplane substrate 300A may be provided.

For example, the backplane substrate 300A may be mounted on the upper side of the chamber (1300 of FIG. 10). The semiconductor light-emitting element 150 may be put into the fluid 1200 before the backplane substrate 300A is mounted in the chamber 1300, or may be put after the backplane substrate 300A is mounted in the chamber 1300.

As illustrated in FIG. 13, a first assembly wiring 321 and/or a second assembly wiring 322, an insulating layer 330, a partition wall 340 having an assembly hole 361 and auxiliary holes 362 and 363 may be formed on the substrate 310 to manufacture the backplane substrate 300A. The partition wall 340 may have multi-stage structure, and neither the first partition-wall layer 341 nor the second partition-wall layer 342 is formed in the assembly hole 361. Only the first partition-wall layer 341 may be formed in the auxiliary holes 362 and 363, and the first partition-wall layer 341 and the second partition-wall layer 342 may be formed on the substrate 310. The thickness T13 of the second partition-wall layer 342 may be equal to or greater than the thickness T11 of the first partition-wall layer 341.

Meanwhile, an AC voltage may be applied to the first assembly wiring 321 and the second assembly wiring 322, so that a DEP force may be formed in the assembly hole 361. At this time, due to the thickness T11 of the first partition-wall layer 341, the DEP force may be weak or not formed in the auxiliary holes 362 and 363.

Thereafter, the semiconductor light-emitting element 150 in the fluid 1200 may be moved along the magnet by the zigzag movement or rotational movement of the magnet. When the semiconductor light-emitting element 150 being moved passes through the corresponding assembly hole 361, it may be assembled into the assembly hole 361 by the DEP force formed in the corresponding assembly hole 361.

As illustrated in FIG. 17, the ashing process may be performed so that the first partition-wall layer 341 in the auxiliary holes 362 and 363 may be removed, so that the first insulating layer 330 may be exposed. Accordingly, since the first partition-wall layer 341 positioned in the lateral direction of the semiconductor light-emitting element 150 assembled in the assembly hole 361 is removed, a space margin in the lateral direction of the semiconductor light-emitting element 150 can be sufficiently secured by the auxiliary holes 362 and 363 from which the first partition-wall layer 341 is removed.

Meanwhile, since an upper surface of the second partition-wall layer 342 is also removed by the ashing process, a thickness of the second partition-wall layer 342 may be reduced from T13 to T12. In this instance, the thickness T12 of the second partition-wall layer 342 may be equal to or smaller than the thickness T11 of the first partition-wall layer 341.

As illustrated in FIG. 18, an etching process may be performed to remove the first insulating layer 330 exposed to the assembly hole 361 and the auxiliary holes 362 and 363, so that the first assembly wiring 321 and/or the second assembly wiring 322 may be exposed.

Thereafter, a metal film 370 may be deposited on the partition wall 340 and the semiconductor light-emitting element 150. Since the metal film 370 is deposited on the auxiliary holes 362 and 363 with sufficiently secured space margin, it may be formed with a sufficient thickness through the auxiliary holes 362 and 363, thereby preventing a disconnection defect.

Meanwhile, since the sizes of the auxiliary holes 362 and 363 are large, grooves 376 and 377 may be formed by the metal film in the auxiliary holes 362 and 363.

Thereafter, an insulating film 351 may be formed on the metal film 370. The insulating film may be formed not only on the grooves 376 and 377 but also on an entire region of the substrate 310. The insulating film 351 may be made of an organic material that is easy to form a thick thickness, but an inorganic material may also be used.

As illustrated in FIG. 19, an ashing process may be performed to remove the remaining insulating film 351 except for the insulating film 351 formed in the grooves 376 and 377. The insulating film 351 formed in the grooves 376 and 377 may become a second insulating layer 350.

Thereafter, an etching process may be performed to etch the metal film 370, so that the connecting electrodes 371 and 372 may be formed.

The first connecting electrode 371 may comprise a first connecting region 371_1 that is in contact with a first side of the semiconductor light-emitting element 150, for example, the electrode 154, a second connecting region 371_2 that extends from the first connecting region 371_1 and is in contact with an upper surface of the first assembly wiring 321 and/or the second assembly wiring 322, and a third connecting region 371_3 that extends from the second connecting region 371_2 and is in contact with an inner side of the first auxiliary hole 362. Likewise, the semiconductor light-emitting element 150 may comprise a first connecting region 372_1 that is in contact with a second side of the electrode 154, a second connecting region 372_2 that extends from the first connecting region 372_1 and is in contact with an upper surface of the first assembly wiring 321 and/or the second assembly wiring 322, and a third connecting region 372_3 that extends from the second connecting region 372_2 and is in contact with an inner side of the second auxiliary hole 363.

The second insulating layer 350 may act as a stopper that prevents the metal film 370 from being etched further below an upper surface of the insulating film 351.

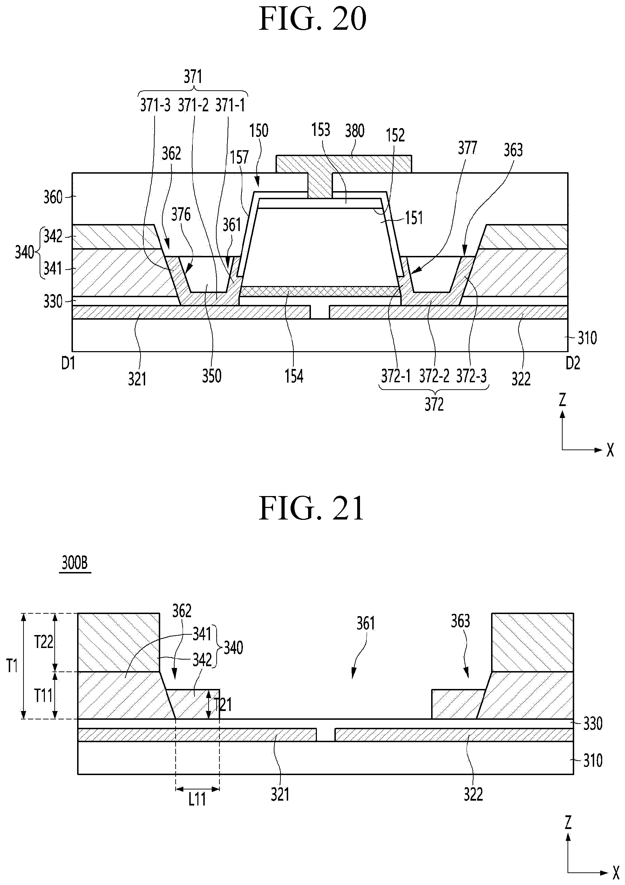

As illustrated in FIG. 20, a third insulating layer 360 may be formed over an entire region of the substrate 310, for example, on the partition wall 340, the second insulating layer 350, and the semiconductor light-emitting element 150, and the third insulating layer 360 and the passivation layer 157 of the semiconductor light-emitting element 150 may be removed to form a contact hole.

Thereafter, an electrode wiring 380 may be formed on the third insulating layer 360, so that the electrode wiring 380 may be electrically connected to an upper side of the semiconductor light-emitting element 150 through the contact hole.

Meanwhile, a partition wall 340 having a multi-stage structure as illustrated in FIG. 21 may be provided on the backplane substrate 300B.

As illustrated in FIG. 21, the partition wall 340 may have a first partition-wall layer 341 and a second partition-wall layer 342. The first partition-wall layer 341 and the second partition-wall layer 342 may not be formed in the assembly hole 361. Unlike FIG. 13, the second partition-wall layer 342 may be formed in the auxiliary holes 362 and 363.

The first partition-wall layer 341 and the second partition-wall layer 342 may be formed on the substrate 310 other than the assembly hole 361 and the auxiliary holes 362 and 363. At this time, the second partition-wall layer 342 may be formed on the first partition-wall layer 341.

The manufacturing process of the backplane substrate 300B according to the second embodiment is as follows. First, a first assembly wiring 321, a second assembly wiring 322, and an insulating layer 330 may be formed on a substrate 310. A first insulating film may be formed on the insulating layer 330, and an assembly hole 361 may be formed by removing a first insulating film corresponding to each of a plurality of pixels to expose the insulating layer 330. The first insulating film other than the assembly hole 361 may be a first partition-wall layer 341 having a thickness T11.

Thereafter, a second insulating film may be formed on the first insulating film, and an exposure process may be performed using a halftone mask. At this time, when the second insulating film is made of a negative photosensitive material, the halftone mask may have a first region having a transmittance of 0% in the second insulating film corresponding to the assembly hole 361, a second region having a transmittance of 30% or less in the second insulating film corresponding to the auxiliary holes 362 and 363, and a third region having a transmittance of 100% in the second insulating film on the remaining region of the substrate 310.

As the exposure and development process is performed, the second insulating film corresponding to the assembly hole 361 may be removed to expose the insulating layer 330, the upper surface of the second insulating film corresponding to the auxiliary holes 362 and 363 may be removed to form the second partition-wall layer 342 with a reduced thickness, and the second insulating film corresponding to the remaining region of the substrate 310 is not removed, so that the second partition-wall layer 342 having a thickness T22 greater than the thickness T21 of the second partition-wall layer 342 in the auxiliary holes 362 and 363 may be formed.

A display device 301 may be manufactured using the backplane substrate 300B according to the second embodiment.

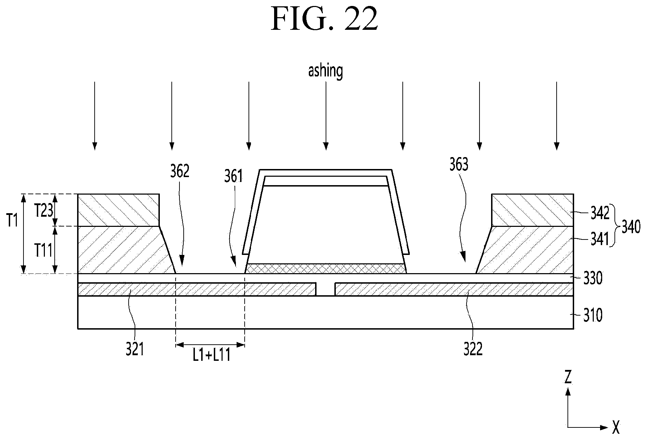

As illustrated in FIG. 22, after the semiconductor light-emitting element 150 is assembled into the assembly hole 361 on the substrate 310 using an assembly process, the second partition-wall layer 342 in the auxiliary holes 362 and 363 may be removed using an ashing process. At this time, since the thickness T22 of the second partition-wall layer 342 on the substrate 310 other than the assembly hole 361 and the auxiliary holes 362 and 363 is greater than the thickness T21 of the second partition-wall layer 342 in the auxiliary holes 362 and 363, even if the second partition-wall layer 342 in the auxiliary holes 362 and 363 is removed, the second partition-wall layer 342 on the substrate 310 other than the assembly hole 361 and the auxiliary holes 362 and 363 may remain with a predetermined thickness T23. The thickness of the second partition-wall layer 342 on the substrate 310 other than the assembly hole 361 and the auxiliary holes 362 and 363 may be reduced from T22 to T23.

### [Second Embodiment]

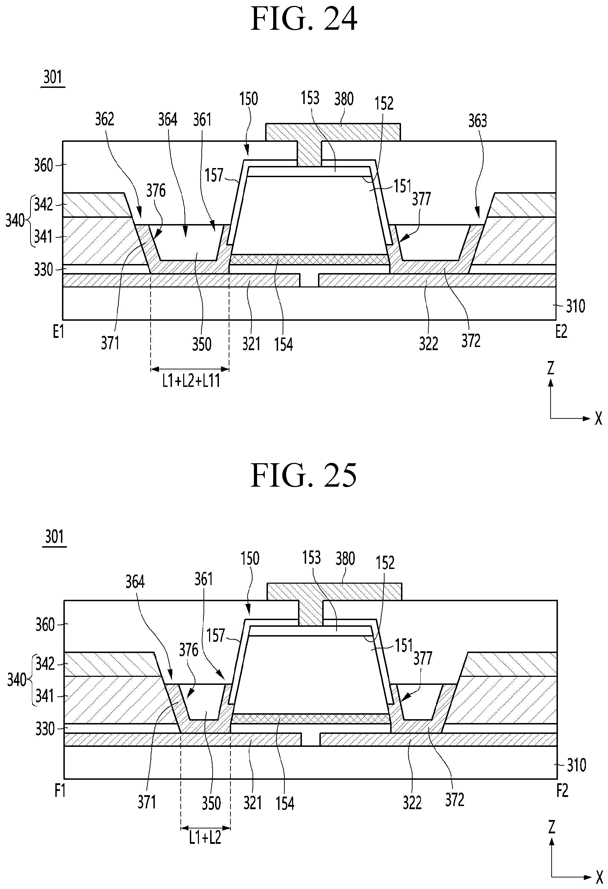

FIG. 23 is a plan view illustrating a display device according to the second embodiment. FIG. 24 is a cross-sectional view taken along line E1-E2 of the display device according to the second embodiment. FIG. 25 is a cross-sectional view taken along line F1-F2 of the display device according to the second embodiment.

The second embodiment is identical to the first embodiment except that the gap (L1+L2) between the outer side of the semiconductor light-emitting element 150 and the inner side of the expansion hole 364 is greater than that in the first embodiment. In the second embodiment, components having the same shape, structure, and/or function as those in the first embodiment are given the same drawing reference numerals and detailed descriptions are omitted.

Referring to FIGS. 23 to 25, the display device 301 according to the second embodiment may comprise a substrate 310, a first assembly wiring 321, a second assembly wiring 322, a first insulating layer 330, a partition wall 340, a second insulating layer 350, connecting electrodes 371 and 372, a third insulating layer 360, and an electrode wiring 380.

The partition wall 340 may comprise an assembly hole 361. The partition wall 340 may have an expansion hole 364 having a second diameter D22 that is greater than a first diameter D11 of the assembly hole 361. In this instance, the expansion hole 364 may be greater than the assembly hole 361 by a distance L2 along the perimeter of the assembly hole 361.

When the semiconductor light-emitting element 150 is assembled into the assembly hole 361, since there is a gap of L1 between the outer side of the semiconductor light-emitting element 150 and the assembly hole 361, there may be a gap of (L1+L2) between the outer side of the semiconductor light-emitting element 150 and the expansion hole 364. That is, the expansion hole 364 may be greater than the semiconductor light-emitting element 150 by a gap of (L1+L2) along the perimeter of the semiconductor light-emitting element 150. Here, L2 may be 2*µ*m or more, but is not limited thereto.

The auxiliary holes 362 and 363 may extend in the outer direction of the expansion hole 364. The auxiliary holes 362 and 363 may be connected or communicated with the expansion hole 364.

The connecting electrodes 371 and 372 may be disposed on a region excluding the semiconductor light-emitting element 150 among the auxiliary holes 362 and 363 as well as the expansion hole 364. Here, the region excluding the semiconductor light-emitting element 150 may be a region corresponding to (L1+L2).

The connecting electrodes 371 and 372 may be formed by patterning a metal film after it has been deposited using a deposition process. At this time, since the metal film is deposited in a region having a sufficient space margin in the lateral direction of the semiconductor light-emitting element 150, it is possible to deposit it thickly. Accordingly, since no disconnection occurs in the connecting electrodes 371 and 372 formed by the patterning of the metal film, lighting defect can be prevented, and the yield can be improved.

Meanwhile, in the second embodiment, the gap between the outer side of the semiconductor light-emitting element 150 and the inner side of the assembly hole 361 may be larger by L2 than the gap L1 between the outer side of the semiconductor light-emitting element 150 and the inner side of the assembly hole 361 in the first embodiment. That is, in the second embodiment, the gap between the outer side of the semiconductor light-emitting element 150 and the inner side of the expansion hole 364 may be (L1+L2). In this way, as the gap between the outer side of the semiconductor light-emitting element 150 and the inner side of the assembly hole 361 in the second embodiment becomes larger, a space margin on the side of the semiconductor light-emitting element 150 may be secured, so that the connecting electrodes 371 and 372 may be connected to the lateral parts of the semiconductor light-emitting element 150 without an interruption even through the gap (L1+L2).

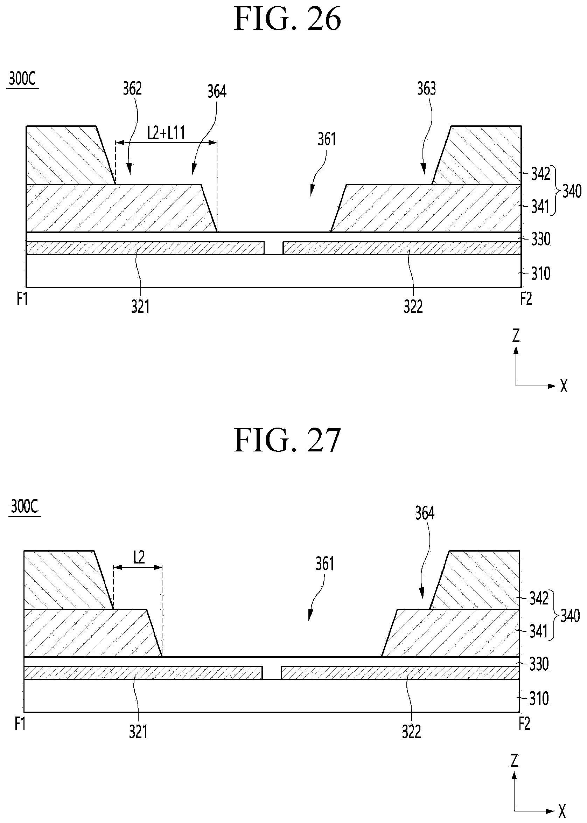

Meanwhile, the display device 301 according to the second embodiment may be manufactured through a self-assembly process and a post-process by using the backplane substrate 300C illustrated in FIGS. 26 and 27.

As illustrated in FIGS. 26 and 27, the backplane substrate 300C may be provided with an assembly hole 361 and auxiliary holes 362 and 363. At this time, the assembly hole 361 does not vertically overlap with the first partition-wall layer 341 and the second partition-wall layer 342, respectively, and the auxiliary holes 362 and 363 vertically overlap with the first partition-wall layer 341, and the first partition-wall layer 341 and the second partition-wall layer 342 may be formed on the remaining substrate 310 except for the assembly hole 361 and the auxiliary holes 362 and 363. In addition, a first partition-wall layer 341 may be formed in a region corresponding to a distance of L2 from the assembly hole 361 in the expansion hole 364.

After the semiconductor light-emitting element 150 is assembled in the assembly hole 361 on the backplane substrate 300C illustrated in FIGS. 26 and 27, when an ashing process is performed, the first partition-wall layer 341 in the auxiliary holes 362 and 363 may be removed. In addition, the first partition-wall layer 341 on a region corresponding to a distance of L2 from the assembly hole 361 in the expansion hole 364 may also be removed. Accordingly, the distance between the outer side of the semiconductor light-emitting element 150 and the inner side of the expansion hole 364 may be (L1+L2), which may be greater than L1 in the first embodiment by L2.

Thereafter, when the deposition process is performed, the metal film may be deposited in the gap (L1+L2) between the outer side of the semiconductor light-emitting element 150 and the inner side of the assembly hole 361 as well as the auxiliary holes 362 and 363. Accordingly, since sufficient space margin is secured on the lateral part along the perimeter of the semiconductor light-emitting element 150, the metal film may be formed relatively thickly.

Accordingly, when the metal film is patterned to form the connecting electrodes 371 and 372, since the connecting electrodes 371 and 372 are connected to the lateral parts of the semiconductor light-emitting element 150 and the first assembly wiring 321 and/or the second assembly wiring 322 without disconnection, lighting defect can be prevented.

### [Third Embodiment]

FIG. 28 is a plan view illustrating a display device according to the third embodiment.

In the following description, drawing symbols not illustrated in FIG. 28 refer to drawings illustrated in FIG. 12, FIG. 24, and 25.

The third embodiment is the same as the first embodiment or the second embodiment except for the auxiliary holes 362-1, 362-2, 363-1, and 363-2 of 4. In the third embodiment, components having the same shape, structure, and/or function as those of the first embodiment or the second embodiment are given the same drawing reference numerals and detailed descriptions are omitted.

Referring to FIG. 28, in the display device 302 according to the third embodiment, a plurality of auxiliary holes 362-1, 362-2, 363-1, and 363-2 may be formed to extend from the assembly hole 361 in a lateral direction.

The plurality of auxiliary holes may comprise a first auxiliary hole and a second auxiliary hole. The first auxiliary hole may comprise a first-first auxiliary hole 362-1 and a first-second auxiliary hole 362-2 on the first assembly wiring 321. The second auxiliary hole may comprise a second-first auxiliary hole 363-1 and a second-second auxiliary hole 363-2 on the second assembly wiring 322.

For example, the first-first auxiliary hole 362-1 and the second-first auxiliary hole 363-1 may be positioned on a first diagonal 391. For example, the first-second auxiliary hole 362-2 and the second-second auxiliary hole 363-2 may be positioned on a second diagonal 392. The first diagonal 391 and the second diagonal 392 may intersect each other at 90 degrees, but are not limited thereto. Accordingly, the first-first auxiliary hole 362-1, the second-first auxiliary hole 363-1, the first-second auxiliary hole 362-2, and the second-second auxiliary hole 363-2 may be spaced apart from each other by 90 degrees with respect to the center of the assembly hole 361.

For example, the first-first auxiliary hole 362-1, the second-first auxiliary hole 363-1, the first-second auxiliary hole 362-2, and the second-second auxiliary hole 363-2 may be positioned radially with respect to the assembly hole 361.

For example, the first-first auxiliary hole 362-1 and the first-second auxiliary hole 362-2 may be disposed on the first assembly wiring 321, and the second-first auxiliary hole 363-1 and the second-second auxiliary hole 363-2 may be disposed on the second assembly wiring 322.

The connecting electrodes (371, 372 of FIGS. 12 and 24) may be disposed in the assembly hole 361, the plurality of auxiliary holes 362-1, 362-2, 363-1 and 363-2, and the expansion hole 364. The first connecting electrode 371 may connect the first side of the semiconductor light-emitting element 150 and the first assembly wiring 321 through the first-first auxiliary hole 362-1 and/or the first-second auxiliary hole 362-2. The second connecting electrode 372 may connect the second side of the semiconductor light-emitting element 150 and the second assembly wiring 322 through the second-first auxiliary hole 363-1 and/or the second-second auxiliary hole 363-2. In addition, the connecting electrodes may be disposed along the perimeter of the semiconductor light-emitting element 150. The connecting electrodes may be disposed in a region excluding the semiconductor light-emitting element 150 among the assembly hole 361 or the expansion hole 364. Therefore, the first connecting electrode 371 and/or the second connecting electrode 372 may be connected to the connecting electrode disposed in a region excluding the semiconductor light-emitting element 150 among the assembly hole 361 or the expansion hole 364.

According to the second embodiment, since more connecting electrodes are electrically connected to the semiconductor light-emitting element 150, a smoother voltage supply is possible, and thus the luminance can be improved.

According to the second embodiment, since the semiconductor light-emitting element 150 is more firmly coupled to the substrate 310 by more connecting electrodes, the bonding strength can be further improved.

According to the second embodiment, since the auxiliary holes 362-1, 362-2, 363-1, and 363-2 are formed at equal intervals from each other, the semiconductor light-emitting element 150 assembled in the assembly hole 361 may be aligned in the correct position without being biased to one side during self-assembly.

Meanwhile, the display device described above may be a display panel. That is, in the embodiment, the display device and the display panel may be understood to have the same meaning. In the embodiment, the display device in a practical sense may comprise a display panel and a controller (or processor) capable of controlling the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, a signage, a mobile terminal such as a mobile phone or a smart phone, a computer display such as a laptop or a desktop, a head-up display (HUD) for an automobile, a backlight unit for a display, a display for VR, AR or mixed reality (MR), a light source, etc.

## Claims

1. A display device, comprising:
a substrate;
a first assembly wiring and a second assembly wiring on the substrate;
a partition wall disposed on the first assembly wiring and the second assembly wiring and having an assembly hole and at least one or more auxiliary hole that extends in an outer direction of the assembly hole;
a semiconductor light-emitting element in the assembly hole; and
a connecting electrode configured to be connected to a lateral part of the semiconductor light-emitting element,
wherein the partition wall comprises:
a first partition-wall layer; and
a second partition-wall layer on the first partition-wall layer, and
wherein an ashing rate of the first partition-wall layer is equal to or greater than an ashing rate of the second partition-wall layer.

2. The display device of claim 1, wherein a viscosity of the first partition-wall layer is equal to or smaller than a viscosity of the second partition-wall layer.

3. The display device of claim 1, wherein a thickness of the second partition-wall layer is equal to or smaller than a thickness of the first partition-wall layer.

4. The display device of claim 1, wherein the auxiliary hole is formed by removing the first partition-wall layer or the second partition-wall layer.

5. The display device of claim 4, wherein the connecting electrode is disposed in the assembly hole and the auxiliary hole.

6. The display device of claim 4, wherein a length of the auxiliary hole is smaller than a width of the first assembly wiring or the second assembly wiring.

7. The display device of claim 4, wherein the auxiliary hole comprises:
at least one or more first auxiliary hole on the first assembly wiring; and
at least one or more second auxiliary hole on the second assembly wiring.

8. The display device of claim 7, wherein the first auxiliary hole and the second auxiliary hole are positioned symmetrically to each other.

9. The display device of claim 4, wherein the partition wall comprises the assembly hole and has an expansion hole that has a second diameter greater than a first diameter of the assembly hole, and
wherein the connecting electrode is disposed between an outer side of the semiconductor light-emitting element and an inner side of the expansion hole.

10. The display device of claim 9, wherein the second diameter of the expansion hole is 2 micrometers or more greater than the first diameter of the assembly hole.

11. The display device of claim 9, wherein the expansion hole is formed by removing the first partition-wall layer.

12. The display device of claim 11, wherein the auxiliary hole is configured to extend in the outer direction of the expansion hole.

13. The display device of claim 1, wherein the first partition-wall layer and the second partition-wall layer each comprise an organic material.

14. The display device of claim 1, wherein a thickness of the partition wall is smaller than a thickness of the semiconductor light-emitting element.
